# EUROPEAN PATENT APPLICATION

(11) **EP 1 684 351 A1**
(43) Date of publication of application: **26.07.2006**
(21) Application number: 05755825.6
(22) Date of filing: 01.07.2005
(51) Int. Cl.: H01L 27/146, H04N 5/335

(54) **SOLID-STATE IMAGE PICKUP DEVICE**

(30) Priority: 07.10.2004 JP 2004295129
(71) Applicant: MATSUSHITA ELECTRIC INDUSTRIAL CO., LTD., Osaka 571-8501 (JP)
(72) Inventor: OHTA, Sougo, Toyama 939-1345 (JP); UCHIDA, Mikiya, Toyama 939-1345 (JP)
(74) Representative: Grünecker, Kinkeldey, Stockmair & Schwanhäusser Anwaltssozietät
(86) International application number: PCT/JP2005/012194
(87) International publication number: WO 2006/038353

(57) **Abstract**

A 3Tr-operated CMOS solid-state imaging apparatus comprises a plurality of pixels including adjacent first and second pixels **230** and **231** including photodiodes **201** for converting light into signal charges and transfer transistors for reading out the signal charges accumulated in the photodiodes, respectively. The first pixel **230** further includes a reset transistor connected at one end to the photodiodes **201** of the first and second pixels **230** and **231** and supplied at the other end with a power voltage, and the second pixel **231** further includes an amplifier transistor having a gate electrode **204** connected to the transfer transistors of the first and second pixel **230** and **231** and supplied at its drain with a power voltage.

## Description

### TECHNICAL FIELD

The present invention relates to a solid state imaging apparatus in which pixels including MOS transistors are formed, and more particularly relates to a pattern layout in a pixel cell and a solid state imaging apparatus having the layout.

### BACKGROUND ART

Solid state imaging devices having a MOS structure of a metal, an oxide and a semiconductor are classified into a field-effect transistor (FET) type and a charge-coupled device (CCD) type according to the manner in which carriers generated by photoelectric conversion travel. Such solid state imaging devices have been used in various fields, such as solar cells, imaging cameras, copying machines, facsimiles, and the like, and the photoelectric conversion efficiency and the integration density of devices have been technically improved. Amplification-type solid state imaging apparatuses including an amplifying device in a pixel includes a sensor in which CMOS transistors are compatible in process with one another (hereinafter, referred to as "CMOS sensor"). A sensor of this type is disclosed in documents, for example, Non-patent Document 1.

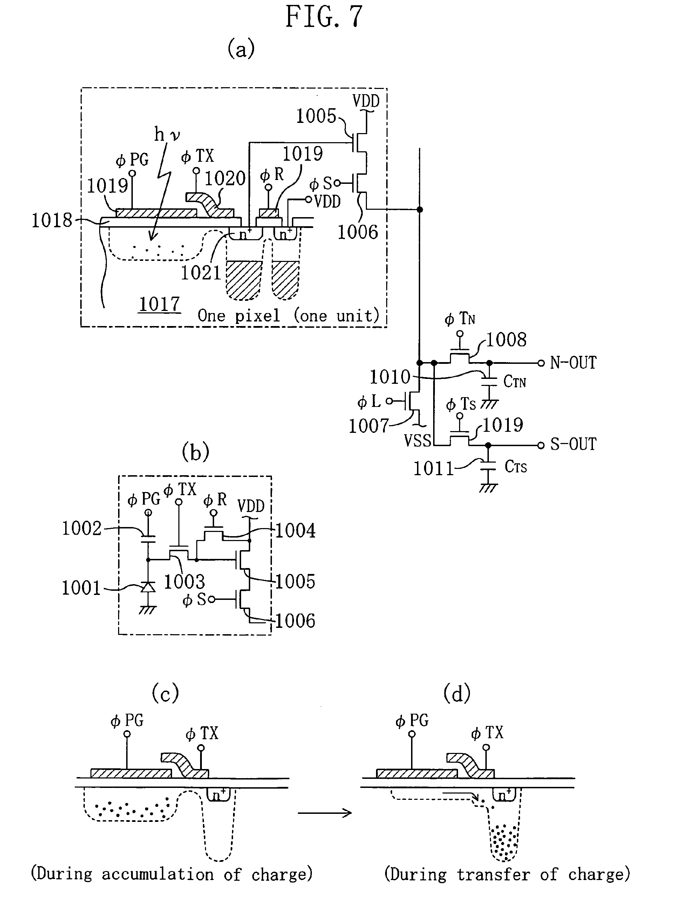

FIG. **7(a)** is a diagram showing a circuit configuration and cross section of a known CMOS sensor disclosed in Patent Document 1, and FIG. **7(b)** is a circuit diagram showing the cross section shown in FIG. **7(a).** FIG. **7(c)** is a diagram showing the state of charges generated by photons **hν** incident on a photoelectric conversion section of the CMOS sensor (hereinafter, referred to as "photodiode") during the accumulation of the charges, and FIG. **7(d)** is a diagram showing the state of charges accumulated in a device.

As shown in FIG. **7(a)** and **7(b),** a known CMOS sensor includes a plurality of pixels having pixel circuits, respectively, source-follower load MOS transistors **1007**, dark output transfer MOS transistors **1008** and bright output transfer MOS transistors **1009** connected to the pixel circuits, dark-output-storage capacitors **1010** formed between the dark output transfer MOS transistors **1008** and the ground, and bright-output-storage capacitors **1011** formed between the bright output transfer MOS transistors **1009** and the ground. Each pixel circuit includes a photodiode **1001** for converting light into electrons (carriers), a photo gate **1002** connected to an output section of the photodiode **1001** and serving as a MOS capacitor, an n-channel type transfer transistor **1003** connected to the output section of the photodiode **1001** and the photo gate **1002** to transfer carriers, an n-channel type reset transistor **1004** connected at one end to the transfer transistor **1003** and supplied at the other end with a power voltage **VDD,** an amplifier transistor **1005** connected at its gate to the transfer transistor **1003** and the reset transistor **1004** and supplied at its drain with the power voltage **VDD,** and an n-channel type select switch transistor **1006** connected to the source of the amplifier transistor **1005.**

Furthermore, as shown in FIG. **7(a),** the pixel circuit of the known CMOS sensor includes a P-type well **1017** formed in a semiconductor substrate, a gate oxide film **1018** formed on the P-type well **1017,** a first-level polySi film **1019** and a second-level polySi film **1020** formed on the gate oxide films **1018,** and an n⁺ floating diffusion (FD) formed in the P-type well **1017.** The first-level polySi film **1019** functions as an electrode of the photo gate **1002** and a gate electrode of the reset transistor **1004.**

One of the features of the known sensor that will be described here is that processes for CMOS transistors in the sensor are fully compatible with one another and MOS transistors of a pixel portion of the sensor and MOS transistors of a peripheral circuit can be formed in the same process step. Therefore, the number of masks and the number of process steps can be significantly reduced as compared with solid-state imaging apparatuses of CCDs.

Next, a method for operating the known CMOS sensor will be briefly described. First, in order to extend a depletion layer under the photo gate **1002,** a positive voltage is applied to a control pulse **ϕPG.** A floating diffusion portion (FD portion) **1021** of a substrate are fixed at power sources VDD during the accumulation of charges in the depletion layer while a control pulse **ϕR** is set to HIGH to prevent blooming. When the irradiation of photons **hν** produces carriers under the photo gate **1002,** electrons are accumulated in the depletion layer under the photo gate **1002,** and positive holes are ejected through the P-type well **1017.**

An energy barrier is formed between the combination of the photodiode **1001** and the P-type well **1017** and the floating diffusion portion **1021** by the transfer transistor **1003.** Therefore, electrons exist under the photo gate **1002** during the accumulation of photo-charges (see FIG. **7(c)**).

Next, when the pixel circuit enters into a reading mode, the control pulse **ϕPG** and the control pulse **ϕTX** are set to eliminate the barrier under the transfer transistor **1003** and completely transfer electrons under the photo gate **1002** to the FD portion **1021** (see FIG. **7(d)).** Since in this process step the electrons are completely transferred to the FD portion **1021,** neither of an after-image and a noise is generated in the photodiode **1001.** When electrons are transferred to the FD portion **1021,** the electric potential of the FD portion **1021** varies according to the number of electrons. The amount of variation in electric potential is delivered through the source of the amplifier transistor **1005** to the select transistor **1006** by a source-follower operation, thereby providing photoelectric conversion characteristics with excellent linearity. A kTC noise due to the resetting of a pixel (thermal noise caused by the parasitic capacitance C produced at the switching on/off of the transistors) is generated in the FD portion **1021.** However, the generated noise can be removed by sampling a dark output before the transfer of carriers generated by photons **hν,** accumulating the sampled dark output and eliminating the difference between the sampled dark output and a bright output. In view of the above, this CMOS sensor is characterized by low noise and high S/N (signal-to-noise) ratio. Since a completely non-destructive read-out method is used, this can provide high versatility. Furthermore, an XY address method of this CMOS sensor provides advantages of high yield and low consumed power.

Next, a pixel configuration of an already-known 4-transistor-operated CMOS sensor will be described.

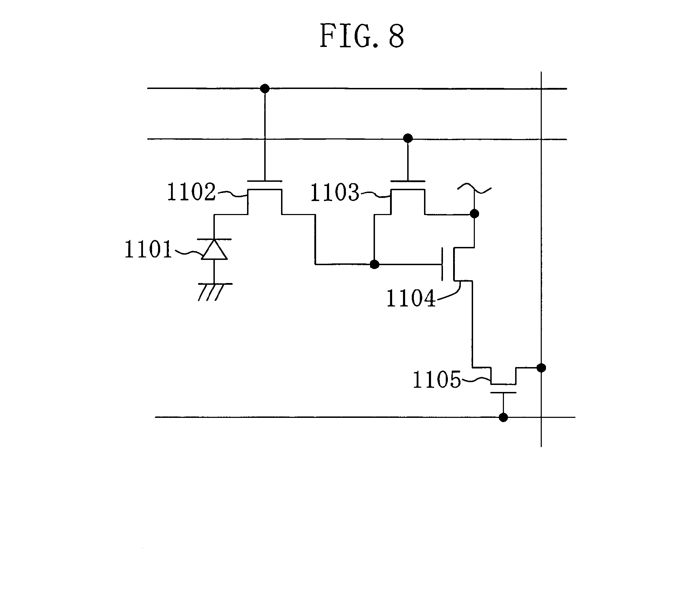

FIG. **8** is a circuit diagram showing a pixel configuration of the known 4-transistor-operated CMOS sensor. In the CMOS sensor of this type, each of pixels includes four transistors, i.e., a transfer transistor **1102,** a reset transistor **1103,** an amplifier transistor **1104,** and a select transistor **1105.** This is why such a CMOS sensor is called a 4Tr-operated CMOS transistor.

As shown in FIG. **8,** the known 4Tr CMOS sensor includes a photodiode **1101** serving as a photoelectric conversion section, a transfer transistor **1102** connected to an output section of the photodiode **1101** to transfer signal charges accumulated in the photodiode **1101,** a reset transistor **1103** for resetting a signal using the charges transferred by the transfer transistor **1102,** an amplifier transistor **1104** for amplifying the signal charges transferred by the transfer transistor **1102,** and a select transistor **1105** connected to the amplifier transistor **1104** to select a pixel.

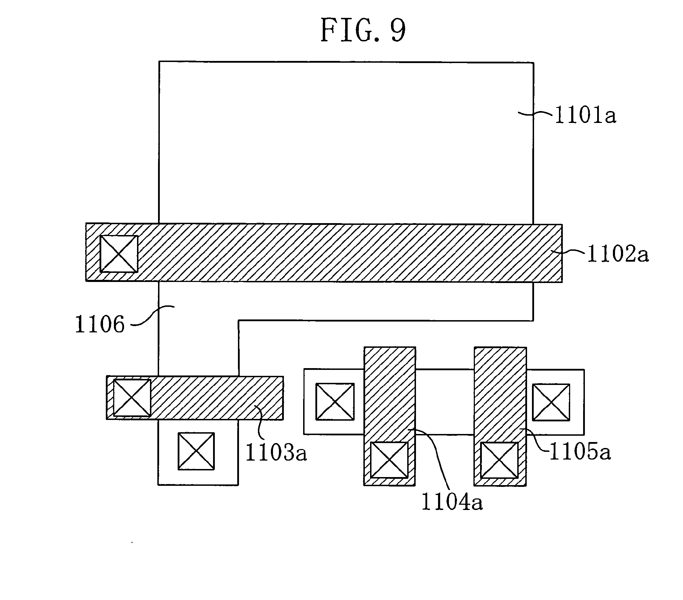

A pixel portion of the above-mentioned 4Tr CMOS sensor including the photodiode **1101,** the transfer transistor **1102,** the reset transistor, the amplifier transistor, and the select transistor is formed to have a pattern, for example, as shown in FIG. **9.**

FIG. **9** is a plan view showing the layout of the pixel portion of the known 4Tr CMOS sensor shown in FIG. **8.** In FIG. **9,** reference numerals **1101a, 1102a, 1103a, 1104a,** and **1105a** denote a photodiode region, the gate of the transfer transistor, the gate of the reset transistor, the gate of the amplifier transistor, and the gate of the select transistor, respectively. Reference numeral **1106** denotes a floating diffusion for converting signal charges accumulated in the photodiode and transferred by the transfer transistor into electric potential.

As seen from the above layout, in the 4Tr CMOS sensor, four transistors, such as an amplifier and transistors for controlling the amplifier, must be arranged in one pixel. This tends to decrease the ratio of the photodiode to the pixel (area ratio) or the ratio of a light-receiving area to the pixel area (aperture ratio). Therefore, in the 4Tr CMOS sensor, the dynamic range, sensitivity, S/N ratio, and the like of the imaging apparatus may be reduced.

On the other hand, in recent years, a pixel configuration of an imaging apparatus in which, in order to miniaturize the size of a pixel cell and enhance the aperture ratio of a photodiode, a pixel is selected by a reset transistor and a select transistor is eliminated has been suggested in Patent Documents 1 and 2. In a solid-state imaging apparatus of this type, a select transistor is eliminated and thus three transistors, i.e., a transfer transistor, a reset transistor and an amplifier transistor, are formed in the interior of each of pixels. This is why the CMOS sensor of this type is called a 3Tr-operated CMOS sensor.

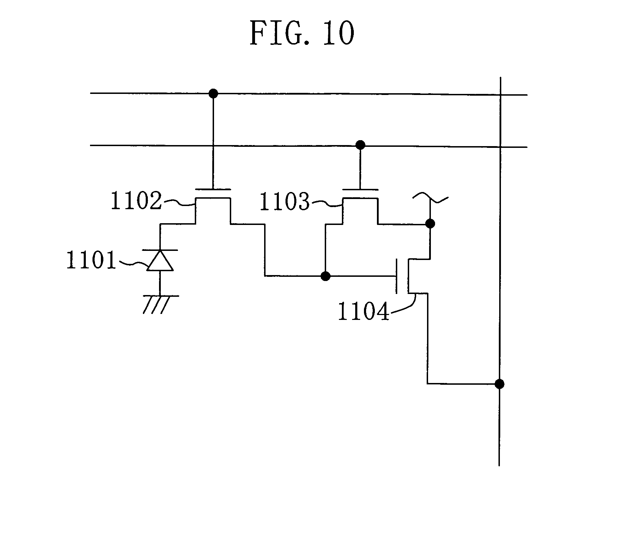

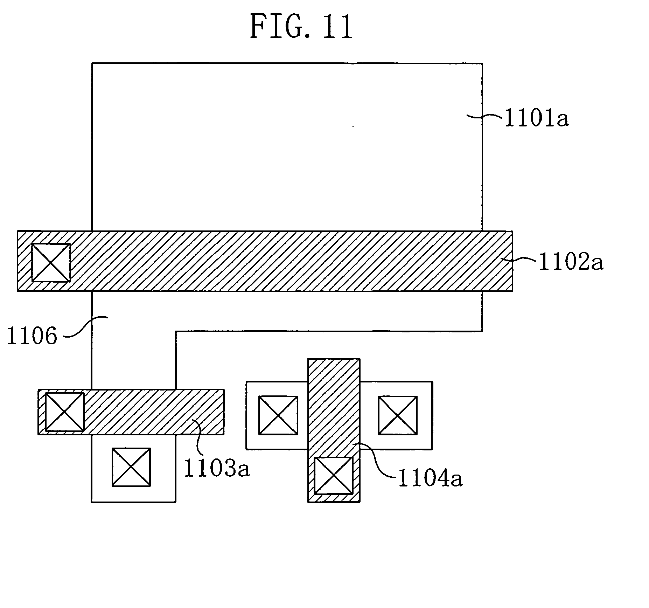

FIG. **10** is a diagram showing a circuit configuration of a pixel of a known 3Tr-operated CMOS sensor. FIG. **11** is a plan view showing the layout of the pixel of the known 3Tr-operated CMOS sensor shown in FIG. **10.**

In the CMOS sensor shown in FIG. **10,** signal charges accumulated in a photodiode **1101** are transferred to a FD portion by a transfer transistor **1102.** The transferred charges are converted into a voltage by an amplifier transistor **1104** and output as a pixel signal. A signal accumulated in the floating diffusion are returned to an initial state by turning a reset transistor **1103** on and ejecting charges. Next, in FIG. **11,** reference numeral **1101a** denotes a photodiode (region), and reference numerals **1102a, 1103a** and **1104a** denote the gates of the transfer transistor, the reset transistor and the amplifier transistor, respectively. The CMOS sensor of this type is characterized in that its area can be reduced by the area of the gate of a select transistor which is not formed in this CMOS sensor.

For the purpose of further improving the prevention of decrease in the aperture ratio of a photodiode without hindering miniaturization in the pixel cell size, a method in which a plurality of pixels share a single amplifier has been suggested as disclosed in Patent Documents 2 and 3.

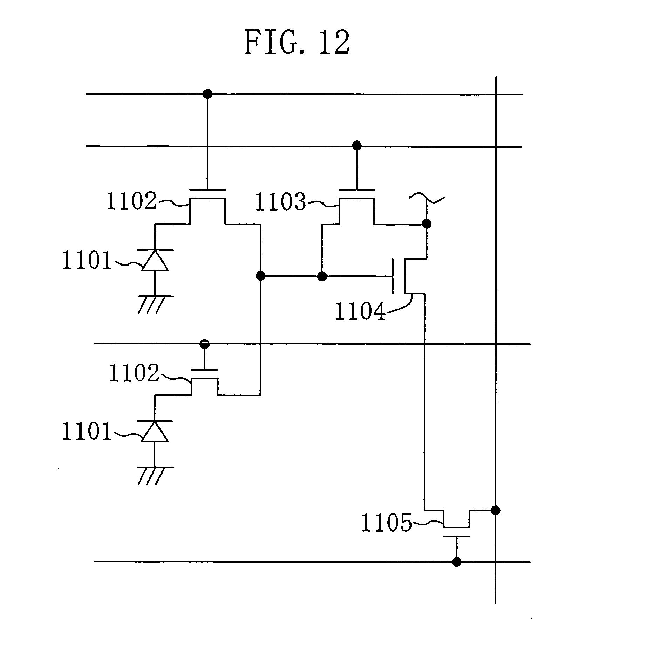

FIG. **12** is a diagram showing an example of the configuration of a known pixel circuit in which two pixels share a single amplifier. FIG. **12** is a diagram showing the configuration of a circuit composed of two pixels. The operation of the known pixel circuit will be described briefly.

First, a transfer transistor **1102** (for example, in the upper pixel in FIG. **12)** in a row of a pixel array in which a signal accumulated in a photodiode **1101** is to be read out is turned on, and the read signal charges are accumulated in a floating diffusion. The accumulated signal charges are converted into a voltage using an amplifier transistor **1104,** and the converted signal charges are externally read out as a pixel signal by turning a select transistor **1105** on. Next, the signal accumulated in the floating diffusion is ejected by turning a reset transistor **1103** on and returned to an initial state. Subsequently, a transfer transistor **1102** (for example, in the lower pixel in FIG. **12)** in a column of the pixel array in which a signal is to be read out is turned on, and the read signal is transferred to the floating diffusion. Subsequent operations of the reset transistor **1103,** the amplifier transistor **1104** and the select transistor **1102** are the same as in the description of the upper pixel.

Although in the pixel circuit an amplifier for signals is shared by adjacent pixels, each pixel has substantially a configuration of a 4Tr CMOS sensor. On the other hand, a solid-state imaging apparatus which has a pixel circuit configuration of substantially a 3Tr-operated CMOS sensor and in which a single amplifier is shared by a plurality of pixels has been suggested in Patent Document 3.

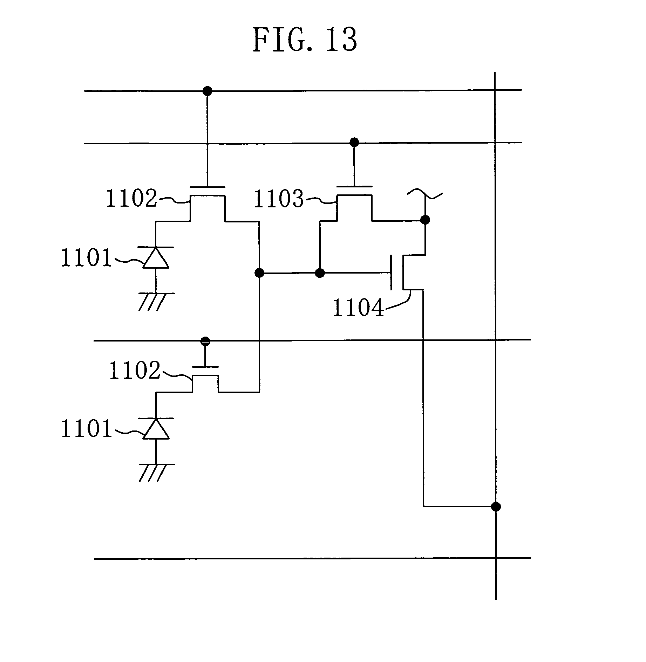

FIG. **13** is a diagram showing a pixel circuit configuration of a known 3Tr-operated CMOS sensor. FIG. **13** is a diagram showing a circuit composed of two pixels.

In the known 3Tr-operated CMOS sensor shown in FIG. **13,** a transfer transistor **1102** (for example, in the upper pixel in FIG. **13)** in a row of a pixel array in which signal charges accumulated in a photodiode **1101** are to be read out is turned on, and the read signal charges are accumulated in a floating diffusion. The accumulated signal is converted into a voltage using an amplifier transistor **1104** and output. Simultaneously, the electric potential of the floating diffusion of a pixel in which signal charges are not to be read out is maintained at 0V, thereby eliminating a select transistor.

Next, a signal accumulated in the floating diffusion is ejected by turning a reset transistor **1103** on and returned to an initial state. Subsequently, a transfer transistor **1102** (for example, in the lower pixel in FIG. **13)** in a column of the pixel array in which a signal is to be read out is turned on, and the read signal is transferred to the floating diffusion. Subsequent operations of the reset transistor **1103,** the amplifier transistor **1104** and the select transistor **1102** are the same as in the description of the upper pixel.
Non-patent document 1: IEEE TRANSACTIONS ON ELECTRON DEVICE, VOL41, PP452-453, 1994
Patent Document 1: Japanese Unexamined Patent Publication No. 9-46596
Patent Document 2: Japanese Unexamined Patent Publication No. 63-100879
Patent Document 3: US Patent No. 6,043,478

### DISCLOSURE OF INVENTION

### Problems that the Invention is to Solve

Although FIG. **11** shows the layout of a pixel cell in which three transistors are arranged, a specific layout of a pixel cell pattern in which two pixels are composed of substantially 4 or 3 transistors is not disclosed in any of Patent Documents 1 through 3.

In an imaging device of a CMOS type, a leak occurs due to a stress applied to a semiconductor substrate, depending on the length of a part of a transistor protruding beyond a gate electrode (finger length) and the location of the transistor in a pixel area. Therefore, shading depending on sensitivity and shading during dark output may occur in a known 3Tr-operated CMOS sensor (imaging device) in which pixels have different layouts of elements.

The present invention has been made to solve the above problems, and it is an object of the present invention to provide an imaging device that can provide a pattern layout of cells with the area of each of pixels reduced and allows pixels to have a uniform layout of elements.

### Means of Solving the Problems

A solid-state imaging apparatus of the present invention comprises a plurality of pixels including adjacent first and second pixels, the first and second pixels including photodiodes formed on a substrate to convert light into signal charges and accumulate the signal charges, transfer transistors having gate electrodes, respectively, and reading out the signal charges accumulated in the photodiodes, and floating diffusions formed in regions of the substrate located to respective one sides of the gate electrodes of the transfer transistors to convert the signal charges read out by the transfer transistors into electric potential, respectively, wherein the first pixel further includes a reset transistor having a gate electrode, connected at one end to the photodiodes of the first and second pixels and supplied at the other end with a power voltage, and the second pixel further includes an amplifier transistor having a gate electrode connected to the transfer transistors of the first and second pixel and amplifying the electric potential into which the signal charges are converted in the associated floating diffusion.

With this structure, the reset transistor and the amplifier transistor can be shared by two pixels (the first and second pixels), and the number of transistors in the first pixel can be made equal to that in the second pixel. This can reduce the known size of each pixel. The size of the photodiode can be increased without reducing the size of the pixel. Therefore, the aperture ratio of the photodiode can be increased as compared with a known imaging apparatus, resulting in the enhanced sensitivity.

It is particularly preferable that the first pixel is formed without the amplifier transistor and the second pixel is formed without the reset transistor.

The plurality of pixels may be arranged in a one-dimensional or two-dimensional manner such that the distance between the centers of the photodiodes in each adjacent two of the plurality of pixels along the direction of alignment thereof is fixed. This can suppress pixel-to-pixel variations in signal output into which incident light is converted.

The first and second pixels may have the same shape and size, and the location of the gate electrode of the reset transistor in the first pixel may be the same as that of the gate electrode of the amplifier transistor in the second pixel. A stress from an isolation film or any other film to each gate electrode can be made uniform on a pixel basis. The amount of leakage current can be made uniform among pixels, resulting in the suppression of shading depending on sensitivity and shading during dark output.

The solid-state imaging apparatus may further comprise: a first contact connected to the reset transistor; and a second contact connected to the amplifier transistor, wherein the location of the first contact in the first pixel is the same as that of the second contact in the second pixel. This can suppress pixel-to-pixel variations in light incident on the photodiode, leading to the suppression of shading.

It is preferable that the solid-state imaging apparatus further comprises: a first contact of metal connected to the reset transistor; and a second contact of metal connected to the amplifier transistor. A refractory metal, such as tungsten, is preferably used as a material of contacts.

The solid-state imaging apparatus further comprises: an interlayer insulating film formed on the pixels; and a microlens formed on a part of the interlayer insulating film located immediately above the photodiode. This can suppress pixel-to-pixel variations in the thickness of the interlayer insulating film according to the geometry of the gate electrodes. Therefore, the solid-state imaging apparatus can restrain variations in the distance between the microlens and the photodiode, resulting in the suppression of shading, such as shading between pixels in even-numbered rows and pixels in odd-numbered rows.

### EFFECTS OF THE INVENTION

According to the solid-state imaging apparatus of the present invention, a reset transistor and an amplifier transistor that are components of a pixel circuit for detecting incident light are arranged in two pixel cells, respectively. These two transistors are shared by two pixel cells. In view of the above, the number of elements incorporated into one pixel cell is reduced, resulting in the reduced pixel area. In this way, pixels can be arranged with a fixed three-dimensional distance between the centers of each adjacent two of photodiodes, and the pitch between each adjacent two of cells can be miniaturized, thereby making the solid-state imaging apparatus compact. Furthermore, since each pixel has a small number of elements, this enhances the aperture ratio of each photodiode, resulting in the improved sensitivity. In this way, a high-performance sensor can be achieved.

### BRIEF DESCRIPTION OF DRAWINGS

[FIG. **1**] FIG. **1** is a diagram showing a pattern layout of pixel cells of a solid-state imaging apparatus according to a first embodiment of the present invention.
[FIG. **2**] FIG. **2** is a circuit diagram showing an example of the solid-state imaging apparatus of the first embodiment.
[FIG. **3**] FIG. **3** is a layout diagram of the solid-state imaging apparatus of the first embodiment in which patterns of contacts for transferring signals to metal interconnects are overlaid on a pattern layout of the interior of the pixels.
[FIG. **4**] FIG. **4** is a diagram showing the layout of 4 × 4 pixels in the solid-state imaging apparatus of the first embodiment.
[FIG. **5**] FIG. **5** is a diagram showing a pattern layout of pixel cells of a solid-state imaging apparatus according to a second embodiment of the present invention.
[FIG. **6**] FIG. **6** is a diagram showing the layout of pixels of a 4Tr CMOS sensor in which an amplifier is shared by a plurality of pixels.
[FIG. **7**] FIG. **7(a)** is a diagram showing a circuit configuration and cross section of a known CMOS sensor; FIG. **7(b)** is a circuit diagram showing the cross section shown in FIG. **7(a)**; FIG. **7(c)** is a diagram showing the state of charges generated by the incidence of photons hv in a photoelectric conversion section during the accumulation of the charges; and FIG. **7(d)** is a diagram showing the state of charges accumulated in a device.
[FIG. **8**] FIG. **8** is a circuit diagram showing a pixel configuration of the known 4Tr CMOS sensor.
[FIG. **9**] FIG. **9** is a plan view showing the layout of the pixel portion of the known 4Tr CMOS sensor shown in FIG. **8**.
[FIG. **10**] FIG. **10** is a diagram showing a circuit configuration of a pixel of a known 3Tr-operated CMOS sensor.
[FIG. **11**] FIG. **11** is a plan view showing the layout of the pixel of the known 3Tr-operated CMOS sensor shown in FIG. **10**.
[FIG. **12**] FIG. **12** is a diagram showing an example of the configuration of a known pixel circuit in which two pixels share a single amplifier.
[FIG. **13**] FIG. **13** is a diagram showing a pixel circuit configuration of a known 3Tr-operated CMOS sensor.

### Description of Numerals

- 113: photodiode regions
- 114: transfer transistor regions
- 115: floating diffusion regions
- 116, 118: reset transistor interconnect regions
- 117: amplifier transistor regions
- 119: horizontal pixel pitch
- 120: vertical pixel pitch
- 201: photodiodes
- 202, 402: gate electrodes of transfer transistors
- 203, 303, 403: gate electrodes of reset transistors
- 204, 304, 404: gate electrodes of amplifier transistors
- 206: floating diffusions
- 207, 212, 307: power supply contacts
- 208, 308: output contacts
- 209, 309: transfer contacts
- 210: transfer interconnect
- 211: output interconnect
- 230: first pixel
- 231: second pixel

### PREFERRED MODE FOR CARRYING OUT THE INVENTION

Embodiments of the present invention will be described hereinafter with reference to the drawings.

### (Embodiment 1)

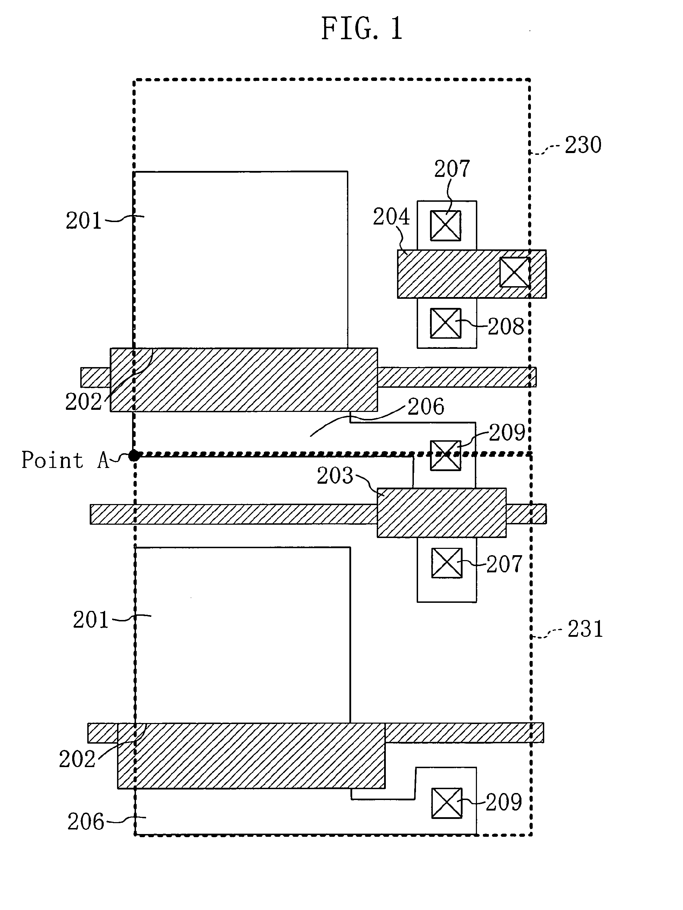

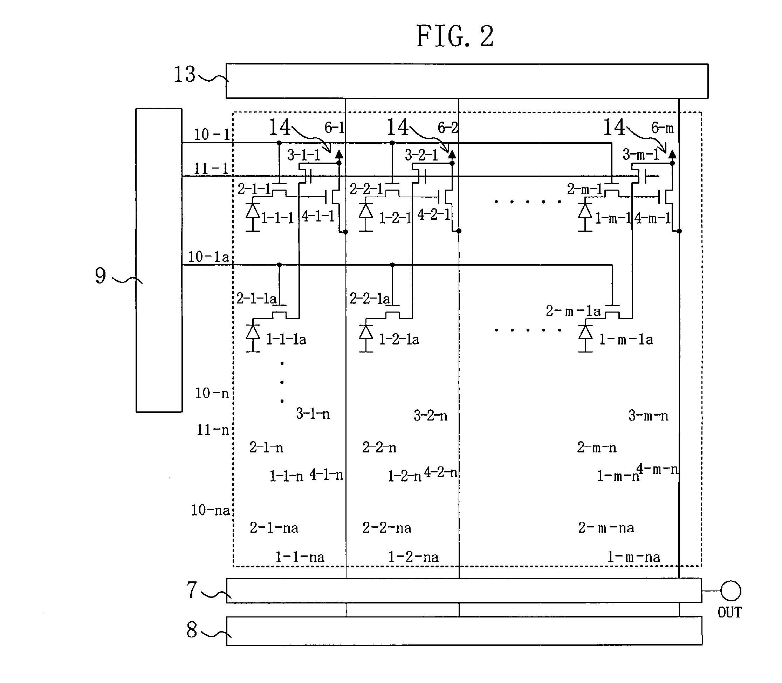

FIG. **1** is a diagram showing a pattern layout of a pixel cell (pixel) of a solid-state imaging apparatus according to a first embodiment of the present invention. Two pixels **230** and **231** are shown in FIG. **1.** FIG. **2** is a circuit diagram showing an example of the solid-state imaging apparatus of this embodiment.

As shown in FIG. **2,** the solid-state imaging apparatus of this embodiment includes photodiodes **1-1-1** through **1-m-n,** transfer transistors **2-1-1** through **2-m-n,** reset transistors **3-1-1** through **3-m-n,** amplifier transistors **4-1-1** through **4-m-n,** row signal lines **6-1** through **6-m,** a row signal accumulating unit **7,** a column-select unit **8,** a row-select unit **9,** transfer-transistor control lines **10-1** through **10-n,** reset-transistor control lines **11-1** through **11-n,** a load transistor group **13,** and a pixel-section power sources **14.** Herein, m and n are both integers of 2 or more.

The photodiodes **1-1-1** through **1-m-n** convert incident light into electrical signals. The transfer transistors **2-1-1** through **2-m-n** transfer the signals produced by the photodiodes **1-1-1** through **1-m-n.** The amplifier transistors **4-1-1** through **4-m-n** amplifies the transferred signal charges. The reset transistors **3-1-1** through **3-m-n** reset the signal charges. The photodiodes **1-1-1** through **1-m-n,** the transfer transistors **2-1-1** through **2-m-n,** the reset transistors **3-1-1** through **3-m-n,** and the amplifier transistors **4-1-1** through **4-m-n** are two-dimensionally arranged in unit cells. In this arrangement, m stages of unit cells are vertically arranged, and n stages of unit cells are horizontally arranged.

The reset-transistor control lines **11-1** through **11-n** are connected to the gates of the reset transistors **3-1-1** through **3-m-n.** The sources of the amplifier transistors **4-1-1** through **4-m-n** are hardwired with row signal lines **6-1** through **6-m,** and a load transistor group **13** is formed at respective one ends of the row signal lines **6-1** through **6-m.** The row signal lines **6-1** through **6-m** are connected at their respective other ends to the row signal accumulating unit **7** including a switch transistor for capturing signals from pixels in one row. The row signal accumulating unit **7** successively produces final outputs in accordance with row-select pulses supplied from the row-select unit **8.**

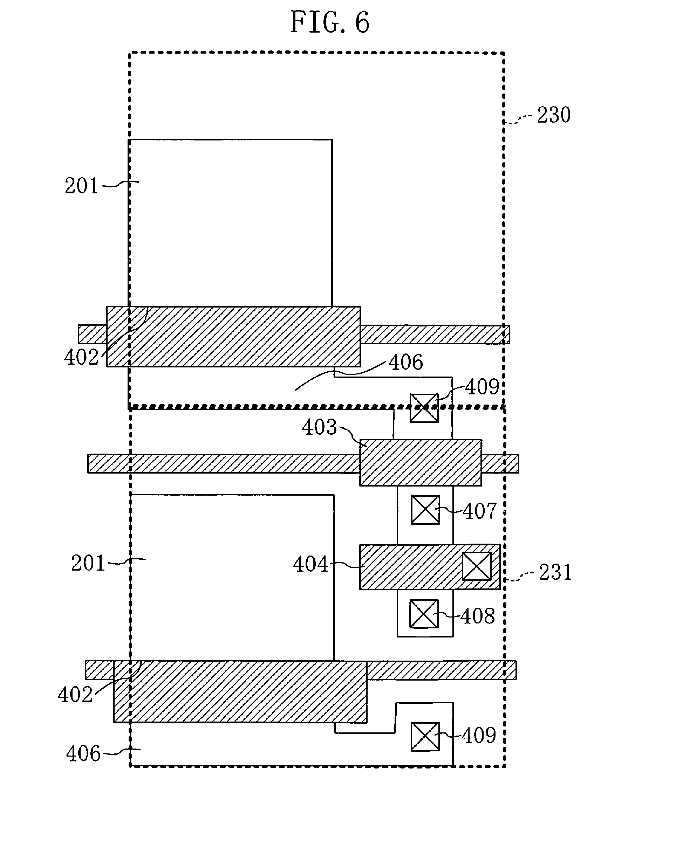

Next, FIG. **1** is a diagram showing a pattern layout of the pixel cells of a CMOS sensor (solid-state imaging apparatus) formed without any select transistor according to the first embodiment of the present invention. In this CMOS sensor, a reset transistor and an amplifier transistor are shared by two pixels. FIG. **1** shows the layout of the CMOS sensor except for the layout of interconnects, such as aluminum interconnects. A pixel circuit of the CMOS sensor has the same configuration as a pixel circuit shown in FIG. 6 in which a plurality of pixels share a single amplifier.

The solid-state imaging apparatus of this embodiment has a plurality of pixels including a first pixel (first pixel cell) **230** and a second pixel (second pixel cell) **231** and arranged in a one-dimensional or two-dimensional manner and a peripheral circuit for handling current flowing from pixel circuits formed in the pixels. The peripheral circuit has the same configuration as the known solid-state imaging apparatus shown in FIG. **7.**

The first and second pixels **230** and **231** both surrounded by dotted lines are arranged to be adjacent to each other at a pixel pitch with respect to the line passing through the point **A** (a point on a floating diffusion) in FIG. **1.** The first and second pixels **230** and **231** are formed with photodiodes **201** for converting light into signal charges (carriers, such as electrons), gate electrodes **202** of transfer transistors for transferring the signal charges accumulated in the photodiodes **201,** and floating diffusions **206** for converting the signal charges accumulated in the photodiodes **201** and transferred by the transfer transistors into electric potentials, respectively.

The first pixel **230** includes a gate electrode **204** of an amplifier transistor for amplifying the signal charges transferred by the transfer transistors and, for example, n-type impurity-diffusion-layer active areas formed in regions of a substrate located to both sides of the gate electrode **204.** An output contact **208** for outputting signals from the first pixel **230** and a power supply contact **207** through which the substrate is connected to a power voltage supply unit are formed on these impurity-diffusion-layer active areas, respectively.

Furthermore, the second pixel **231** includes a gate electrode **203** of a reset transistor for resetting the signal transferred by the transfer transistors, for example, n-type impurity-diffusion-layer active areas formed in regions of the substrate located to both sides of the gate electrode **203,** a transfer contact **209** formed on one of the impurity-diffusion-layer active areas to transfer the signal converted into electric potential in the floating diffusion **206** to the amplifier transistor, and a power supply contact **207** formed on the other one of the impurity-diffusion-layer active areas to supply a power supply voltage to the pixel circuit. The floating diffusion **206** in the first pixel **230** is continuously formed with one of the impurity-diffusion-layer active areas located to one side of the gate electrode **203** of the reset transistor.

In the above-mentioned layout, adjacent first and second pixels **230** and **231** share a single amplifier transistor and a single reset transistor. Therefore, in the solid-state imaging apparatus of this embodiment, the number of transistors formed in each pixel is two. This can reduce the size of each pixel (cell) as compared with the known solid-state imaging apparatus. This can provide a solid-state imaging apparatus of this embodiment with a higher sensitivity and a higher S/N ratio than that of the known art. In addition, the aperture ratio of each photodiode can be further enhanced without reducing the size of the pixel.

A photodiode **201** and two MOS transistors are formed in each pixel of the solid-state imaging apparatus of this embodiment. Thus, the number of transistors per pixel varies less than that in the known solid-state imaging apparatus.

If more transistors were formed in one of the first and second pixels **230** and **231** than in the other one thereof, the layout of each pixel would significantly vary, leading to problems. To be specific, if one transistor was formed in the first pixel and three transistors were formed in the second pixel, a large area of the second pixel would be occupied by the gates of the transistors. This makes it difficult to miniaturize the area of each cell or enhance the aperture ratio of each photo diode.

FIG. **6** is a diagram showing an example of a pattern layout of a CMOS sensor in which one transistor is formed in a first pixel **230** and three transistors are formed in a second pixel **231.** In FIG. 6, the same reference numerals are given to some of the same components as in FIG. **1.**

In the pattern layout shown in FIG. **6,** gate electrodes **402** of transfer transistors are formed in the pixels **230** and **231,** respectively. However, since in the second pixel **231** a gate electrode **404** of an amplifier transistor is formed between a gate electrode **403** of a reset transistor and the gate electrode **402** of the transfer transistor, these gate electrodes occupy a large area of the pixel cell. This makes it difficult to vertically downscale (miniaturize) each cell in FIG. **6.** Meanwhile, a blank space exists in an area of the first pixel **230** adjacent to the photodiode **201.** In view of the above, a balance is not achieved between the layouts of the first and second pixels **230** and **231.**

On the other hand, in the pattern layouts of pixels of the solid-state imaging apparatus of this embodiment, a transfer transistor and a gate electrode **204** of an amplifier transistor are formed in a pixel **230,** and a transfer transistor and a gate electrode **203** of a reset transistor are formed in a second pixel **231.** This enables effective use to be made of spaces in both the pixels, resulting in the further reduced area of each pixel as compared with that of the known solid-state imaging apparatus including 4 or 3 transistors per pixel. Alternatively, the area of each photodiode can be increased without reducing the area of the pixel, resulting in the increased aperture ratio of the photodiode.

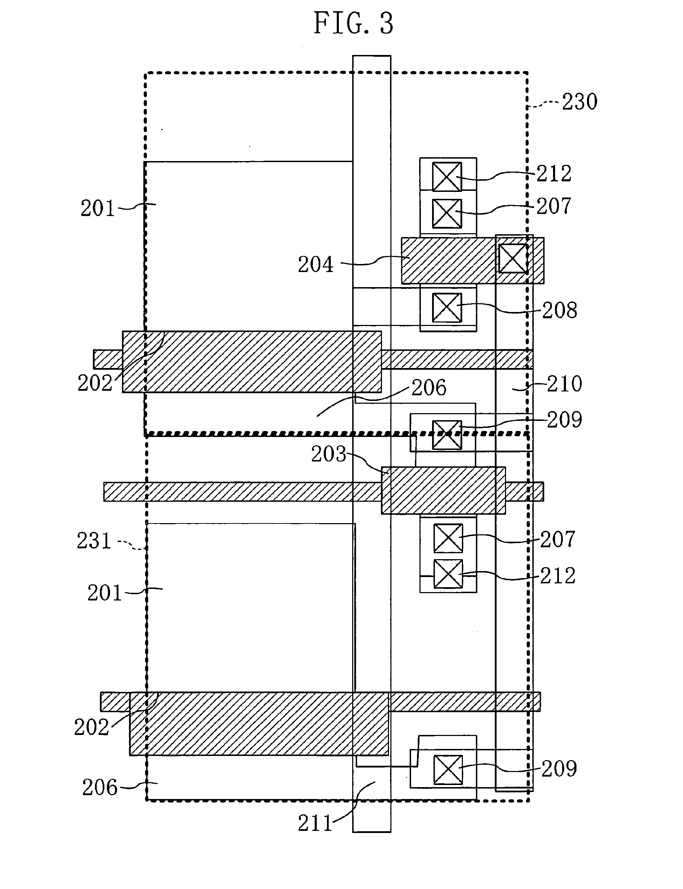

FIG. **3** is a layout diagram of the solid-state imaging apparatus of the first embodiment in which patterns of first-level metal interconnects and transfer contacts for transferring signals from the first-level metal interconnects to second-level metal interconnects (not shown) are overlaid on the pattern layout of the pixels of the solid-state imaging apparatus of the first embodiment shown in FIG. **1.**

As shown in FIG. **3,** a floating diffusion **206** of each pixel sharing an amplifier transistor with another pixel is connected through a transfer contact **209** to a transfer interconnect **210** forming one of the first-level metal interconnects, shares a region with a source region of a reset transistor (an impurity diffusion region having the same type as the floating diffusion layer), and is connected through a contact to a gate electrode **204** of the amplifier transistor. In the layout shown in FIG. **3,** power is externally supplied through an unshown second-level metal interconnect, a power supply contact **212,** the transfer interconnect **210** forming one of the first-level metal interconnects, and a power supply contact **207** to the reset transistor and the amplifier transistor. As seen from the above, the transfer interconnect **210** functions as an interconnect for transferring a charge signal converted into electric potential in the floating diffusion **206** to the amplifier transistor.

Furthermore, charges produced by light incident on a photodiode **201** are delivered through an output contact **208** and an output interconnect **211.** In other words, the output interconnect **211** is an interconnect through which the signal converted into electric potential is to be read out. As seen from the above, the layout of pixels of the solid-state imaging apparatus of this embodiment allows metal interconnects to be routed without variations in the density of the interconnects.

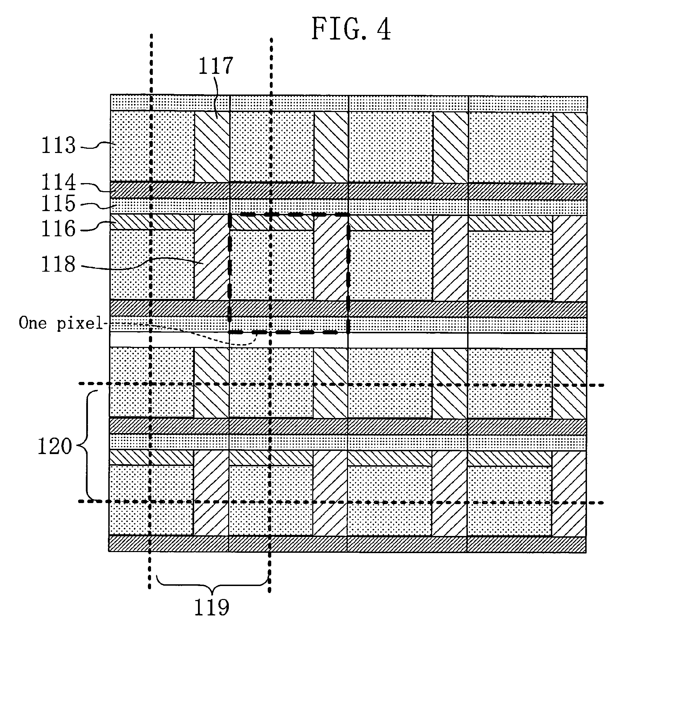

FIGS. **1** and **3** show two pixels, i.e., the minimum number of pixels needed to explain the layout of the solid-state imaging apparatus in which an amplifier transistor and a reset transistor are shared by two pixels. However, in an actual solid-state imaging apparatus, a large number of pixels are arranged in the form of an array. FIG. **4** shows a schematic layout of a solid-state imaging apparatus when 4 rows × 4 columns = 16 pixels are arranged.

A pixel array shown in FIG. **4** is characterized in that a vertical pixel pitch **120** of the pixel array and a horizontal pixel pitch **119** thereof relative to the center of each photodiode are equal to each other. The center of the photodiode herein means the point on which of the photodiode light vertically incident on the imaging apparatus has the highest intensity. A region surrounded by bold dotted lines in FIG. **4** corresponds to one pixel.

As seen from the correspondence between FIGS. **4** and **1,** each of pixels includes a photodiode region **113** in which a photodiode is placed, a transfer transistor region **114** in which a transfer transistor is placed, a floating diffusion region **115** in which a floating diffusion is placed, reset transistor interconnect regions **116** and **118** in which a gate interconnect for a reset transistor is placed, and an amplifier transistor region **117** in which an amplifier transistor is placed. Pixel cells are arranged such that pixels in which reset transistors are formed, such as a second pixel **231** shown in FIG. **1,** and pixels in which amplifier transistors are formed, such as a first pixel **230** shown in FIG. **1,** are alternately arranged along the row. Alternatively, the pixel cells can be arranged in the other manners. For example, pixels A including reset transistors and pixels B including amplifier transistors may be vertically arranged in the order of ABBAABBA.... Otherwise, pixel cells can be arranged in various ways in view of convenience of the layouts of first-level and second-level metal interconnects connected to the whole pixel array.

### (Embodiment 2)

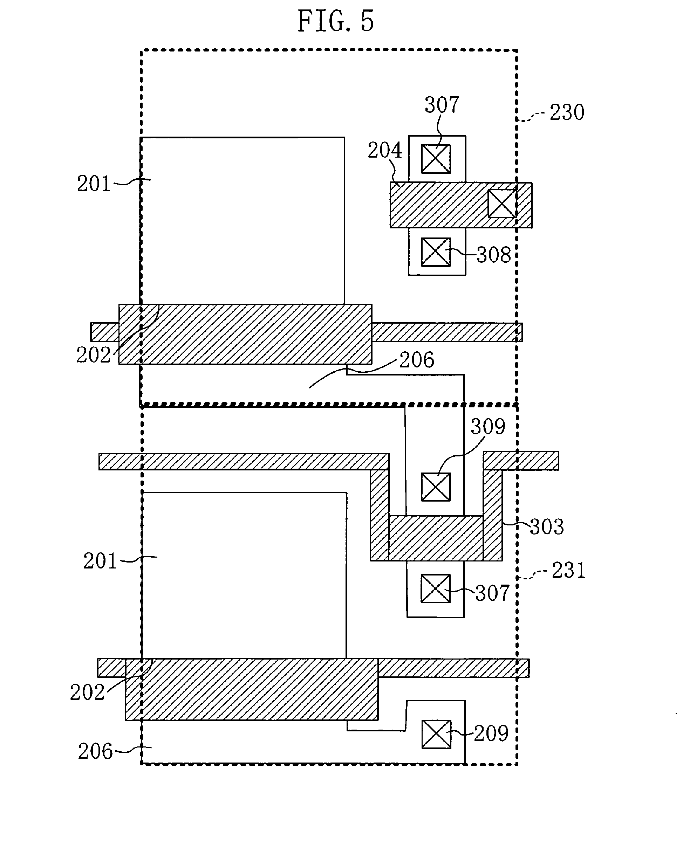

FIG. **5** is a diagram showing a pattern layout of pixel cells of a solid-state imaging apparatus according to a second embodiment of the present invention. Shown in FIG. **5** are specific two of a large number of pixel cells periodically arranged in the solid-state imaging apparatus to have the same shape. The pattern layout of pixel cells of this embodiment is for a 3Tr-operated CMOS sensor in which a reset transistor and an amplifier transistor are shared by two pixels as in the first embodiment. Furthermore, FIG. **5** shows the pattern layout of the pixel cells except for the layout of interconnects, such as aluminum interconnects. The pixel cells of the solid-state imaging apparatus of this embodiment have the same circuit configuration as the pixel circuit shown in FIG. **13** in which one amplifier is shared by a plurality of pixels.

Adjacent first and second pixels **230** and **231** each have a photodiode **201,** a transfer transistor for transferring signal charges accumulated in the photodiode **201,** and a floating diffusion **206** for converting the signal charges transferred by the transfer transistor into electric potential. While an amplifier transistor for amplifying the signal charges transferred by the transfer transistor is formed in the first pixel **230,** a gate electrode **303** of a reset transistor is formed in the second pixel **231.**

Pixels of the solid-state imaging apparatus of this embodiment have the same size and shape. Respective photodiodes **201** of pixels are substantially equal in shape and intra-pixel location (coordinate), respective gate electrodes **202** of transfer transistors thereof are substantially equal in shape and intra-pixel location, and various contacts (power supply contacts **307,** output contacts **308** and transfer contacts **309)** thereof are substantially equal in shape and intra-pixel location. Respective impurity-diffusion-layer active areas and floating diffusions **206** of pixels are also made as equal in size and intra-pixel location as possible. Furthermore, a gate electrode **204** of an amplifier transistor of the first pixel **230** is substantially equal in intra-pixel location (coordinate) to a gate electrode **303** of a reset transistor of the second pixel **231.** Respective impurity diffusion layers of the first and second pixels **230** and **231** corresponding to active regions of the transistors have as similar a pattern as possible.

In view of the above, the solid-state imaging apparatus of this embodiment allows the suppression of shading produced due to pixel-to-pixel differences in the layout of elements. In solid-state imaging apparatuses, as described above, a leak occurs, depending on the length of a part of a transistor protruding beyond a gate electrode of the transistor toward the boundary between an active region and an isolation (finger length) and the location of the transistor in a pixel area. If vertically arranged pixels in FIG. **5** varied in the layout and intra-pixel location of transistors, the conditions under which leaks occur vary according to each pixel. Shading depending on sensitivity and shading during dark output may occur due to different amounts of leakage current between pixel circuits located in even-numbered rows and pixel circuits located in odd-numbered rows. However, according to the solid-state imaging apparatus of this embodiment, the uniformity of the layout of elements for circuits located in pixels can suppress malfunction due to shading.

Furthermore, recent solid-state imaging apparatuses employ tungsten plugs obtained by filling contact holes with a refractory metal, such as tungsten. Since in this case light obliquely incident on pixels reflects also on tungsten plugs, differences in the intra-pixel location of contacts cause variations in light incident on photodiodes. Furthermore, in recent solid-state imaging apparatuses, an interlayer insulating film is formed to cover gate electrodes of transistors in pixel cells, and then the top surface of the interlayer insulating film is planarized by chemical mechanical polishing (CMP). In spite of this, differences in the intra-pixel locations of gate electrodes of transistors cause variations in flatness. However, according to the solid-state imaging apparatus of this embodiment, the intra-pixel locations of gate electrodes are equal to one another, thereby making the top surface of an interlayer insulating film flat.

A microlens is usually formed in a part of the uppermost layer of each pixel (a layer formed on an interlayer insulating film) opposed to a photodiode formed on a semiconductor substrate. Thus, variations in flatness of the interlayer insulating film cause variations in the thickness thereof, resulting in variations in the distance between the microlens and the photodiode. This produces pixel-to-pixel differences in light-gathering ability, leading to differences among signals obtained by subjecting light to photoelectronic conversion. Furthermore, when there are differences between parts of the interlayer insulating film located on even-numbered pixels and those located on odd-numbered pixels based on layout differences among pixels, this causes shading between the even-numbered pixels and the odd-numbered pixels. Since the solid-state imaging apparatus of this embodiment suppresses variations in the intra-pixel location of each contact and the thickness of an interlayer insulating film, the above shading problem can be solved.

In the solid-state imaging apparatus of this embodiment, i.e., a CMOS sensor of a 3Tr-operated pixel configuration, two transistors, i.e., a transfer transistor and an amplifier transistor or a transfer transistor and a reset transistor, are placed in each pixel like the solid-state imaging apparatus of the first embodiment. This can reduce the area of each pixel cell. Alternatively, the aperture ratio of each photodiode can be increased without reducing the area of the known pixel cell.

### INDUSTRIAL APPLICABILITY

The pattern layout of the solid-state imaging apparatus of the present invention can be applied to solid-state imaging apparatuses in which one pixel is formed with a plurality of MOS transistors. The solid-state imaging apparatuses can be applied to various devices, such as copying machines, surveillance cameras, digital cameras, and sensors.

## Claims

1. A solid-state imaging apparatus comprising a plurality of pixels including adjacent first and second pixels, the first and second pixels including photodiodes formed on a substrate to convert light into signal charges and accumulate the signal charges, transfer transistors having gate electrodes, respectively, and reading out the signal charges accumulated in the photodiodes, and floating diffusions formed in regions of the substrate located to respective one sides of the gate electrodes of the transfer transistors to convert the signal charges read out by the transfer transistors into electric potential, respectively,
wherein the first pixel further includes a reset transistor having a gate electrode, connected at one end to the photodiodes of the first and second pixels and supplied at the other end with a power voltage, and
the second pixel further includes an amplifier transistor having a gate electrode connected to the transfer transistors of the first and second pixel and amplifying the electric potential into which the signal charges are converted in the associated floating diffusion.

2. The solid-state imaging apparatus of Claim 1, wherein
the first pixel is formed without the amplifier transistor, and
the second pixel is formed without the reset transistor.

3. The solid-state imaging apparatus of Claim 1, wherein
the plurality of pixels are arranged in a one-dimensional or two-dimensional manner such that the distance between the centers of the photodiodes in each adjacent two of the plurality of pixels along the direction of alignment thereof is fixed.

4. The solid-state imaging apparatus of Claim 1, wherein
the first and second pixels have the same shape and size, and
the location of the gate electrode of the reset transistor in the first pixel is the same as that of the gate electrode of the amplifier transistor in the second pixel.

5. The solid-state imaging apparatus of Claim 1 further comprising:
a first contact connected to the reset transistor; and
a second contact connected to the amplifier transistor,
wherein the location of the first contact in the first pixel is the same as that of the second contact in the second pixel.

6. The solid-state imaging apparatus of Claim 1 further comprising:
a first contact of metal connected to the reset transistor; and
a second contact of metal connected to the amplifier transistor.

7. The solid-state imaging apparatus of Claim 4 further comprising:
an interlayer insulating film formed on the pixels; and
a microlens formed on a part of the interlayer insulating film located immediately above the photodiode.
